# EUROPÄISCHE PATENTANMELDUNG

(11) **EP 2 214 205 A2**
(43) Veröffentlichungstag der Anmeldung: **04.08.2010**
(21) Anmeldenummer: 10151614.4
(22) Anmeldetag: 26.01.2010
(51) Int. Cl.: H01L 25/16

(54) **Elektrooptisches Halbleitermodul und Halbleitermodulschaltung**

(30) Priorität: 29.01.2009 DE 102009006629
(71) Anmelder: Continental Automotive GmbH, 30165 Hannover (DE)
(72) Erfinder: Baur, Frank, 90482 Nürnberg (DE); Deml, Ulrich, 93138 Lappersdorf (DE); Götte, Carsten Dr., 93080 Pentling / Großberg (DE)

(57) **Zusammenfassung**

Die Erfindung betrifft ein elektrooptisches Halbleitermodul (1) mit mindestens einem Datenkommunikationschip (6) und einem elektrooptischen Chip (7). Die Chips (6, 7) sind in einem gemeinsamen Kunststoffgehäuse (8) eingebettet und stehen über Verbindungselemente (9) elektrisch in Verbindung. Der elektrooptische Chip (7) ist auf dem Datenkommunikationschip (8) fixiert. Das Kunststoffgehäuse (8) weist eine Sende- und Empfangsöffnung (10) auf, durch welche optische Strahlung (11) von oder zu dem elektrooptischen Chip (7) aus- und/oder eintritt.

## Beschreibung

Die Erfindung betrifft ein elektrooptisches Halbleitermodul mit mindestens einem Datenkommunikationschip und einem elektrooptischen Chip. Die Chips sind in einem gemeinsamen Kunststoffgehäuse eingebettet und stehen über Verbindungselemente elektrisch in Verbindung.

Ein derartiges Modul ist für LED als elektrooptischer Chip aus der Druckschrift US 2006 0022214 A1 bekannt. Das Modul enthält eine LED in einem LED-Gehäuse, das eine elektronische zusätzlich montierte Komponente aufweist, die das durch den LED-Chip emittierte Licht steuert. Die elektronische Komponente ist auf einem Substrat neben der LED montiert und kann eine Treiberhardware, eine Netzwerkschnittstelle, einen Speicher, einen Prozessor, eine schaltbare Leistungsversorgung oder eine andere Art einer elektronischen Komponente aufweisen. Derart aufgebaute Module haben den Nachteil, dass sie eine große Fläche des Substrats beanspruchen und damit auch ein größeres Kunststoffgehäuse benötigen, um eine elektronische Komponente wie einen Datenkommunikationschip, einen elektrooptischen Chip wie einen LED-Chip zu integrieren.

Aufgabe der Erfindung ist es, ein Halbleitermodul und eine Halbleiterschaltung zu schaffen, die Raum sparend ist und minimale Dimensionen aufweist. Außerdem ist es Aufgabe der Erfindung, neue Wege der Datenübertragung zu eröffnen.

Diese Aufgabe wird mit dem Gegenstand der unabhängigen Ansprüche gelöst. Vorteilhafte Weiterbildungen der Erfindung ergeben sich aus den abhängigen Ansprüchen.

Erfindungsgemäß wird ein elektrooptisches Halbleitermodul mit mindestens einem Datenkommunikationschip und einem elektrooptischen Chip geschaffen. Die Chips sind in einem gemeinsamen Kunststoffgehäuse eingebettet und stehen über Verbindungselemente elektrisch in Verbindung. Der elektrooptische Chip ist auf dem Datenkommunikationschip fixiert. Das Kunststoffgehäuse weist eine Sende- und Empfangsöffnung auf, durch welche optische Strahlung von oder zu dem elektrooptischen Chip aus- und/oder eintritt. Dieses Halbleitermodul hat den Vorteil, dass auf engstem Raum ein Datenkommunikationschip mit einem elektrooptischen Chip kombiniert sind und Daten über optische Pfade austauschen und übertragen können.

In einer Ausführungsform der Erfindung weist die Sende- und Empfangsöffnung eine transparente Kunststofffüllung auf. Eine derartige transparente Kunststofffüllung stützt einerseits den empfindlichen elektrooptischen Chip und andererseits behindert es die optische Strahlung nicht am Austritt durch die Sende- und Empfangsöffnung. Weiterhin kann die Sende- und Empfangsöffnung ein Linsensystem aufweisen, um den optischen Strahl zu bündeln oder zu streuen.

In einer weiteren Ausführungsform der Erfindung ist es vorgesehen, die Sende- und Empfangsöffnung auf einer Oberflächenmontageseite des Halbleitermoduls anzuordnen und auf dieser Oberflächenmontageseite Kugelkontakte vorzusehen. Dabei soll die Sende- und Empfangsöffnung mindestens anstelle einer Kugelkontaktposition auf der Oberflächenmontageseite angeordnet werden. Dieses Halbleitermodul hat den Vorteil, dass für die Sende- und Empfangsöffnung keine zusätzliche Fläche erforderlich ist, sondern vielmehr nur eine Kugelkontaktposition durch die Sende- und Empfangsöffnung in Anspruch genommen wird.

Außerdem kann die Sende- und Empfangsöffnung gegenüberliegend zu der Oberflächenmontageseite des Halbleitermoduls angeordnet sein. In diesem Fall wird die optische Strahlung genau entgegengesetzt von dem Halbleitermodul ausgehen.

Schließlich ist es vorgesehen, dass der elektrooptische Chip auf der Oberseite und ein weiterer elektrooptischer Chip auf der Rückseite des Datenkommunikationschips angeordnet sind und das Halbleitermodul Sende- und Empfangsöffnungen sowohl zur Oberflächenmontageseite als auch zu der gegenüberliegenden Seite hin aufweist. Damit kann ein Halbleitermodul realisiert werden, durch das ein optischer Pfad hindurchgeführt wird. Jedoch kann durch die Zwischenschaltung des Datenkommunikationsmoduls ein optischer Strahl in dem Halbleitermodul modifiziert und beispielsweise auf die gegenüberliegende Seite wieder abgestrahlt werden.

Weiterhin ist es vorgesehen, eine Halbleitermodulschaltung zu realisieren, bei der mehrere Halbleitermodule gemäß den vorhergehenden Varianten auf einer Schaltungsplatine mit Glasfaserverstärkung angeordnet sind und über die Glasfasern der Glasfaserverstärkung optisch miteinander kommunizieren. Dabei ist ein pulskodemodulierter multiplexer bzw. zeitversetzter Zugriff der Datenkommunikationschips über die elektrooptischen Chips auf das Glasfasergewebe vorgesehen.

In einer weiteren Ausführungsform ist es vorgesehen, dass das Halbleitermodul mehrere Datenkommunikationschips mit elektrooptischen Chips und optischen Sende- und Empfangsöffnungen um ein Durchgangsfenster gruppiert aufweist, wobei die Datenkommunikationschips des Halbleitermoduls über die elektrooptischen Chips und die Sende- und Empfangsöffnungen untereinander kommunizieren. Dazu werden die Sende- und Empfangsöffnungen vorzugsweise gegenüberliegend in dem Halbleitermodul aus mehreren Datenkommunikationschips angeordnet.

Vorzugsweise weist ein derartiges Halbleitermodul vier Datenkommunikationschips mit elektrooptischen Chips auf, wobei die elektrooptischen Chips und die optischen Sende- und Empfangsöffnungen um ein rechtwinkliges Durchgangsfenster gruppiert sind. Dabei kommunizieren gegenüberliegende Datenkommunikationschips des Halbleitermoduls über die elektrooptischen Chips und die Sende- und Empfangsöffnungen miteinander. Ein derartiges Modul hat eine quaderförmige Ausdehnung und weist in seiner Mitte ein Datenkommunikationsfenster auf, durch das beispielsweise eine Glasfaserleitung als optischer Pfad gelegt werden kann.

Daher ist es vorgesehen, dass das Halbleitermodul Kühlfahnen aufweist, auf denen der Datenkommunikationschip montiert ist, wobei Enden der Kühlfahnen aus den Seitenflächen des Kunststoffgehäuses herausragen. Diese Kühlfahnen können zusätzlich durch aktive Kühlung über Kühlleitungen intensiv gekühlt werden, wobei die Kühlleitungen mit den Kühlfahnen mechanisch verbunden sind.

Ferner ist es vorgesehen, eine Halbleitermodulschaltung zu realisieren, bei der mehrere Halbleitermodule mit Durchgangsfenster auf einer Schaltungsplatine derart angeordnet sind, dass sich ein zentraler optischer Kommunikationspfad durch die Durchgangsfenster erstreckt, und ein pulskodemodulierter multiplexer bzw. zeitversetzter Zugriff der Datenkommunikationschips über die elektrooptischen Chips auf den zentralen optischen Kommunikationspfad vorgesehen ist. Eine derartige Halbleitermodulschaltung hat den Vorteil, dass eine große Datenmenge auf kleinstem Raum verarbeitet, transportiert und weitergegeben werden kann.

Die Erfindung wird nun anhand der beigefügten Figuren näher erläutert.
- Figur 1: zeigt schematische Darstellungen eines elektroopti- schen Halbleitermoduls gemäß einer ersten Ausfüh- rungsform der Erfindung;
- Figur 2: zeigt schematische Darstellungen des elektroopti- schen Halbleitermoduls gemäß Figur 1 mit seitlich angeordneten Kühlfahnen;
- Figur 3: zeigt schematische Darstellungen eines elektroopti- schen Halbleitermoduls gemäß einer zweiten Ausfüh- rungsform der Erfindung;
- Figur 4: zeigt schematische Darstellungen des elektroopti- schen Halbleitermoduls gemäß Figur 3 mit Kühlfah- nen;
- Figur 5: zeigt schematische Darstellungen eines elektroopti- schen Halbleitermoduls gemäß einer dritten Ausfüh- rungsform der Erfindung;
- Figur 6: zeigt einen schematischen Querschnitt durch eine Modifikation des elektrooptischen Halbleitermoduls gemäß Figur 1;
- Figur 7: zeigt einen schematischen Querschnitt durch eine weitere Modifikation des elektrooptischen Halblei- termoduls gemäß Figur 1;
- Figur 8: zeigt einen schematischen Querschnitt durch eine weitere Modifikation des elektrooptischen Halblei- termoduls gemäß Figur 1;
- Figur 9: zeigt einen schematischen Querschnitt durch eine weitere Modifikation des elektrooptischen Halblei- termoduls gemäß Figur 1;
- Figur 10: zeigt schematische Darstellungen einer Halbleiter- schaltung eines elektrooptischen Halbleitermoduls gemäß Figur 1 auf einer glasfaserverstärkten Plati- ne;
- Figur 11: zeigt eine schematische perspektivische Darstellung eines elektrooptischen Halbleitermoduls gemäß einer vierten Ausführungsform der Erfindung;
- Figur 12: zeigt einen schematischen Querschnitt durch das e- lektrooptische Modul gemäß Figur 11;
- Figur 13: zeigt einen schematischen Querschnitt durch ein e- lektrooptisches Halbleitermodul gemäß einer fünften Ausführungsform der Erfindung;
- Figur 14: zeigt eine schematische Darstellung einer Halblei- terschaltung auf einer Platine mit elektrooptischen Halbleitermodulen gemäß Figur 11.

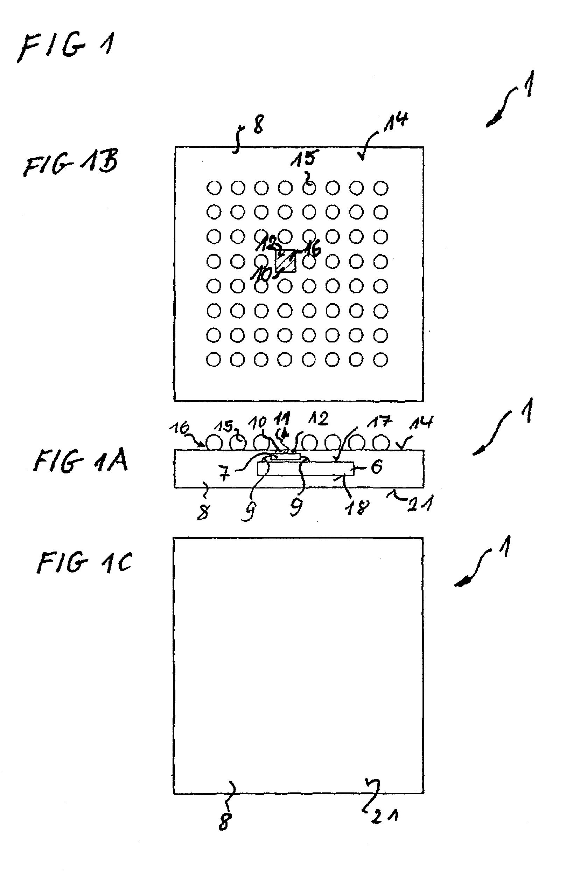

Figur 1 zeigt schematische Darstellungen eines elektrooptischen Halbleitermoduls 1 gemäß einer ersten Ausführungsform der Erfindung.

Dabei zeigt Figur 1A einen Querschnitt durch dieses Halbleitermodul 1, das in ein Kunststoffgehäuse 8 eingebettet ist und auf seiner Oberflächenmontageseite 14 Kugelkontakte 15 in Kugelkontaktpositionen 16 aufweist. In dem Kunststoffgehäuse 8 ist ein Datenkommunikationschip 6 eingebettet und dient gleichzeitig als Substrat eines elektrooptischen Chips 7, der in der Lage ist, optische Signale in Form von optischen Strahlen 11 zu emittieren. Der Datenkommunikationschip 6 weist dazu auf der Oberseite 17 Verbindungselemente 9 auf, über die Datenmengen im elektrooptischen Chip 7 von dem Datenkommunikationschip 6 übertragen werden, so dass diese Datenmengen als optische Signale vom elektrooptischen Chip 7 über eine Sende- und Empfangsöffnung 10 abgestrahlt werden können.

Die Sende- und Empfangsöffnung 10 ist mit einer transparenten Kunststofffüllung 12 versehen, so dass der elektrooptischen Chip 7 geschützt ist. Ein derartiges Halbleitermodul unterscheidet sich von dem Stand der Technik dadurch, dass hier ein Datenkommunikationschip 6 als Substrat und Träger für ein elektrooptisches Chip 7 eingesetzt wird, wodurch in vorteilhafter Weise die Verbindungselemente 9 deutlich verkürzt werden können und die Oberflächenstruktur des Datenkommunikationschips optimal auf die Struktur des elektrooptischen Chips abgestimmt werden kann. Demgegenüber sind aus dem Stand der Technik lediglich Halbleitermodule bekannt, bei denen Datenkommunikationschips aufeinander gestapelt werden, während bei elektrooptischen Halbleitermodulen der elektrooptische Halbleiterchip streng getrennt von einem Logikchip oder Datenkommunikationschip in einem Kunststoffgehäuse angeordnet wird, was deutlich längere Verbindungselemente bedingt und derartige Halbleitermodule störanfälliger macht.

Figur 1B zeigt eine Draufsicht auf die Oberflächenmontageseite 14 des Halbleitermoduls 1, wobei die Matrix der Kugelkontaktpositionen 16, die weitestgehend mit Kugelkontakten 15 bewegt werden, zu sehen ist. Nur eine der Kugelkontaktpositionen 16 ist als Sende- und Empfangsöffnung 10 ausgebildet, durch die eine optische Kopplung des Halbleitermoduls mit anderen optischen Komponenten einer Halbleiterschaltung möglich ist. In dieser Ausführungsform der Erfindung ist, wie bereits oben erwähnt, diese Sende- und Empfangsöffnung 10 mit einer transparenten Kunststofffüllung 12 aufgefüllt.

Figur 1C zeigt eine Draufsicht auf eine der Oberflächenmontageseite 14 gegenüberliegende Seite 21 des elektrooptischen Halbleitermoduls, die bei dieser Ausführungsform der Erfindung vollkommen unstrukturiert bleibt und lediglich die Umrisse des Kunststoffgehäuses 8 verdeutlicht.

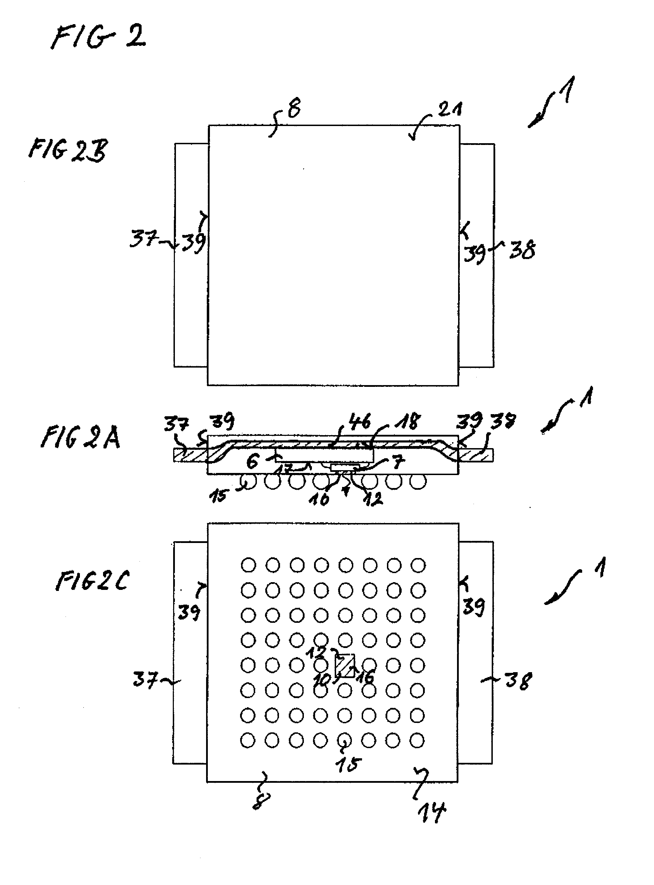

Figur 2 zeigt schematische Darstellungen des elektrooptischen Halbleitermoduls 1 gemäß Figur 1 mit seitlich angeordneten Kühlfahnen 37 und 38. Diese seitlich angeordneten Kühlfahnen 37 und 38 bilden eine Wärmesenke für die beiden aufeinander angeordneten bzw. gestapelten Chips, wobei der Datenkommunikationschip 6 auf einer thermischen Brücke 46 mit seiner Rückseite 18 montiert ist. Die thermische Brücke 46 steht dabei mit den Kühlfahnen 37 und 38 an den Seitenflächen 39 des Kunststoffgehäuses thermisch in Verbindung, so dass der Stapel aus Kommunikationschip 6 und elektrooptischem Chip 7 intensiv gekühlt wird.

Figur 2B zeigt wiederum eine Seite 21 des elektrooptischen Halbleitermoduls 1, die der Oberflächemontageseite 14 des elektrooptischen Halbleitermoduls 1 gegenüberliegt.

Figur 2C zeigt schematisch die Oberflächenmontageseite 14 des elektrooptischen Halbleitermoduls 1, die wiederum in einer Kugelkontaktposition 16 die Sende- und Empfangsöffnung 10 des elektrooptischen Halbleiterchips mit transparenter Kunststoffauffüllung 12 zeigt.

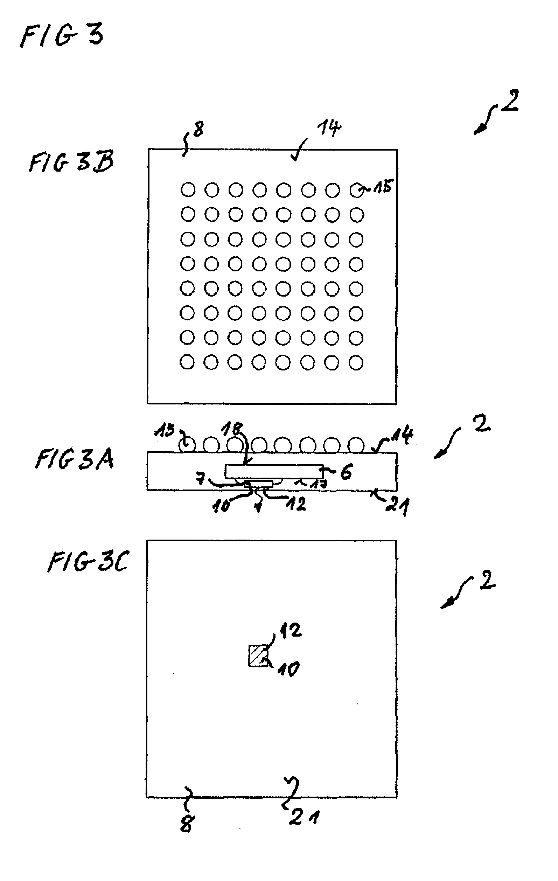

Figur 3 zeigt schematische Darstellungen eines elektrooptischen Halbleitermoduls 2 gemäß einer zweiten Ausführungsform der Erfindung. Komponenten mit gleichen Funktionen wie in den vorhergehenden Figuren werden mit gleichen Bezugszeichen gekennzeichnet und nicht extra erörtert.

Figur 3A zeigt einen Querschnitt durch das elektrooptische Halbleitermodul 2. Das elektrooptische Halbleitermodul 2 unterscheidet sich von dem in den Figuren 1 und 2 gezeigten Halbleitermodul 1 darin, dass diesmal der elektrooptische Chip zu der Seite 21 ausgerichtet ist, die der Oberflächemontageseite 14 des Halbleitermoduls 2 gegenüberliegt. Folglich ist in Figur 3B keine Kugelkontaktposition 16 für die Sende- und Empfangsöffnung vorgesehen, da bei dieser Ausführungsform der Erfindung die Sende- und Empfangsöffnung 10 in die Seite 21 eingebracht ist, wie es die Figur 3C zeigt.

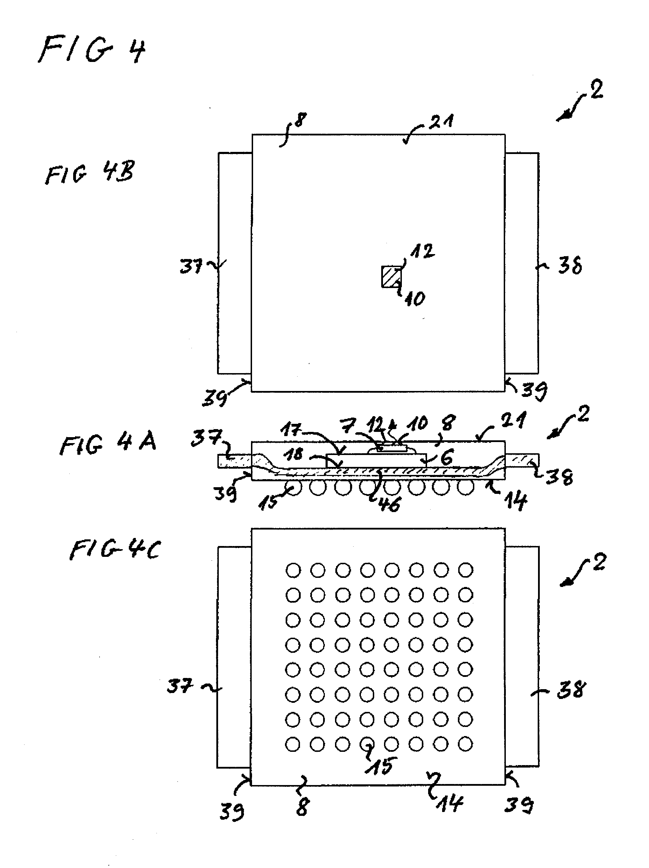

Figur 4 zeigt schematische Darstellungen des elektrooptischen Halbleitermoduls 2 gemäß Figur 3 mit Kühlfahnen 37 und 38. Das Prinzip ist ähnlich wie bei der ersten Ausführungsform der Erfindung. Der Stapel aus einem Kommunikationschip 6 und einem elektrooptischen Chip 7 kann über die Kühlfahnen 37 und 38 gekühlt werden, da der Kommunikationschip 6 auf einer thermischen Brücke 46 angeordnet ist, welche mit den Kühlfahnen 37 und 38 thermisch in Verbindung steht.

Da der elektrooptische Chip 7 zu der Seite 21 des elektrooptischen Halbleitermoduls 2 ausgerichtet ist, zeigt die Figur 4B eine Sende- und Empfangsöffnung 10, während die Oberflächenmontageseite 14 von Figur 4C sämtliche Kugelkontaktpositionen 16 mit Kugelkontakten belegt hat.

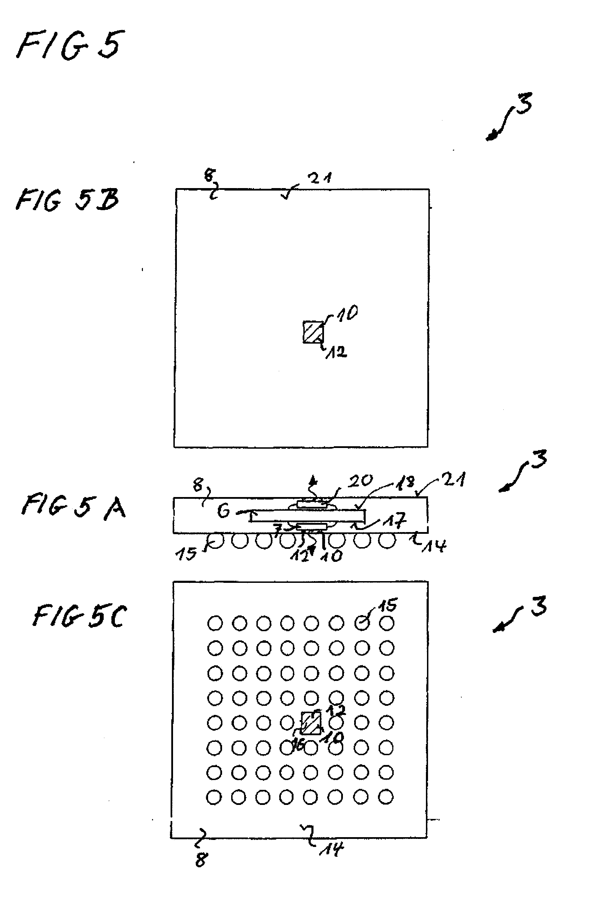

Figur 5 zeigt schematische Darstellungen eines elektrooptischen Halbleitermoduls 3 gemäß einer dritten Ausführungsform der Erfindung. Komponenten mit gleichen Funktionen wie in den vorhergehenden Figuren werden mit gleichen Bezugszeichen gekennzeichnet und nicht extra erörtert.

Figur 5A zeigt wiederum einen Querschnitt durch diese dritte Ausführungsform der Erfindung. Der Unterschied zu den vorhergehenden Ausführungsformen besteht darin, dass zusätzlich zu dem elektrooptischen Halbleiterchip 7 auf der Oberseite 17 ein weiterer elektrooptischer Halbleiterchip 20 auf der Rückseite 18 des Datenkommunikationschips 6 angeordnet ist. Damit ist es möglich, zu beiden Seiten des elektrooptischen Halbleitermoduls optische Signale auszusenden.

Wird anstelle von optischen Strahlern wie LED oder Laserdioden ein elektrooptischer Transceiver eingesetzt, der sowohl einen optischen Sender als auch einen optischen Empfänger umfasst, können optische Daten durch den Datenkommunikationschip ergänzt werden und als optische Signale weitergeleitet werden. Dies ist besonders nützlich bei optischen Verstärkern, die beispielsweise in Glasfaserleitungen nach endlichen Entfernungen einzubauen sind, um ein optisches ankommendes Signal verstärkt weiterzugeben. Besonders vorteilhaft ist es jedoch, ein derartiges elektrooptisches Halbleitermodul im Kfz-Bau für zentrale Steuereinheiten einzusetzen, da dadurch die Störsicherheit derartiger Steuereinheiten vergrößert werden kann.

Aufgrund der beiden elektrooptischen Halbleiterchips 7 und 20 zeigt sowohl die Figur 5B auf der Seite 21 des Halbleitermoduls 3 eine Sende- und Empfangsöffnung 10 als auch die Figur 5C auf der Oberflächenmontageseite 14, welche mit einer Sende- und Empfangsöffnung 10 ausgestattet ist.

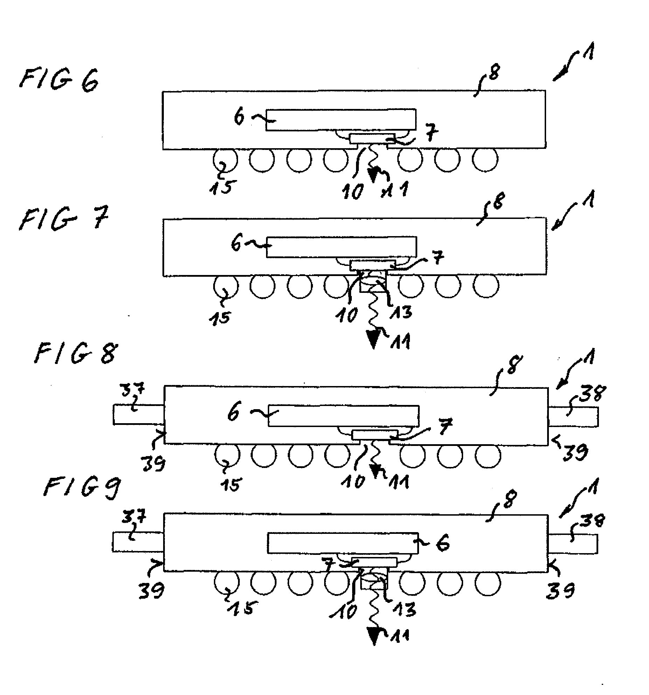

Figur 6 zeigt einen schematischen Querschnitt durch eine Modifikation des elektrooptischen Halbleitermoduls 1 gemäß Figur 1. Die Modifikation besteht darin, dass in dieser Ausführungsform der Erfindung keinerlei Schutzabdeckung des elektrooptischen Halbleiterchips vorgesehen ist und die Sende- und Empfangsöffnung 10 frei von jeder Beschichtung gehalten wird. Dieses ist dann von Vorteil, wenn das Halbleitermodul gemäß Figur 6 in einem mit Inertgas gefüllten Gehäuse eingebaut ist.

Figur 7 zeigt einen schematischen Querschnitt durch eine weitere Modifikation des elektrooptischen Halbleitermoduls 1 gemäß Figur 1, bei dem ein Linsensystem 13 angeordnet ist, um beispielsweise die optische Strahlung 11 zu fokussieren.

Figur 8 zeigt einen schematischen Querschnitt durch eine weitere Modifikation des elektrooptischen Halbleitermoduls 1 gemäß Figur 1, wobei sich diese Modifikation gemäß Figur 8 von der Modifikation gemäß Figur 6 dadurch unterscheidet, dass zusätzlich Kühlfahnen 37 und 38 aus Seitenflächen 39 des elektrooptischen Moduls 1 herausragen.

Figur 9 zeigt einen schematischen Querschnitt durch eine weitere Modifikation des elektrooptischen Halbleitermoduls 1 gemäß Figur 1, wobei diese Modifikation sich von der Modifikation gemäß Figur 7 dadurch unterscheidet, dass auch hier an den Seitenflächen 39 des Halbleitermoduls 1 aus dem Kunststoffgehäuse 8 Kühlfahnen 37 und 38 herausragen.

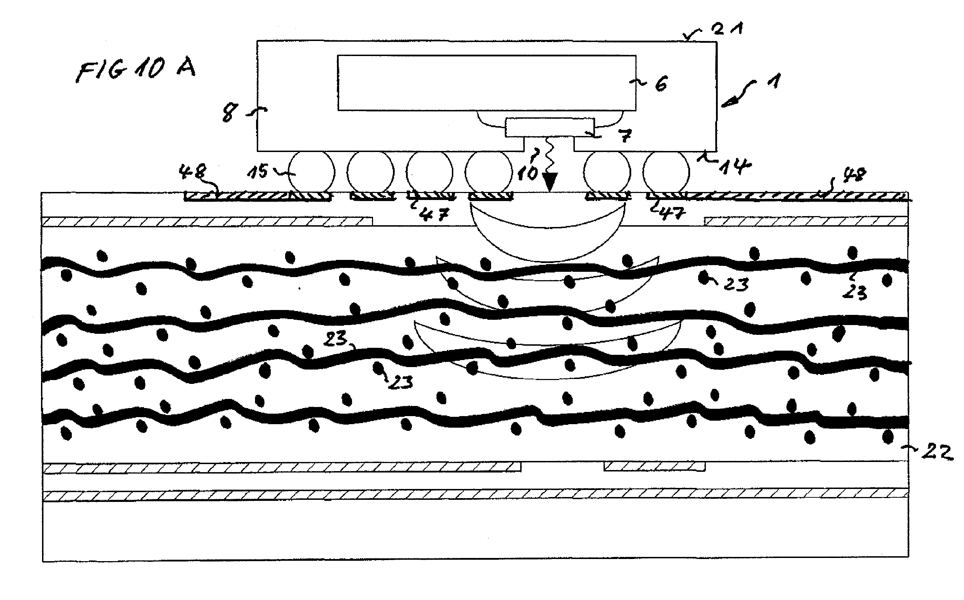

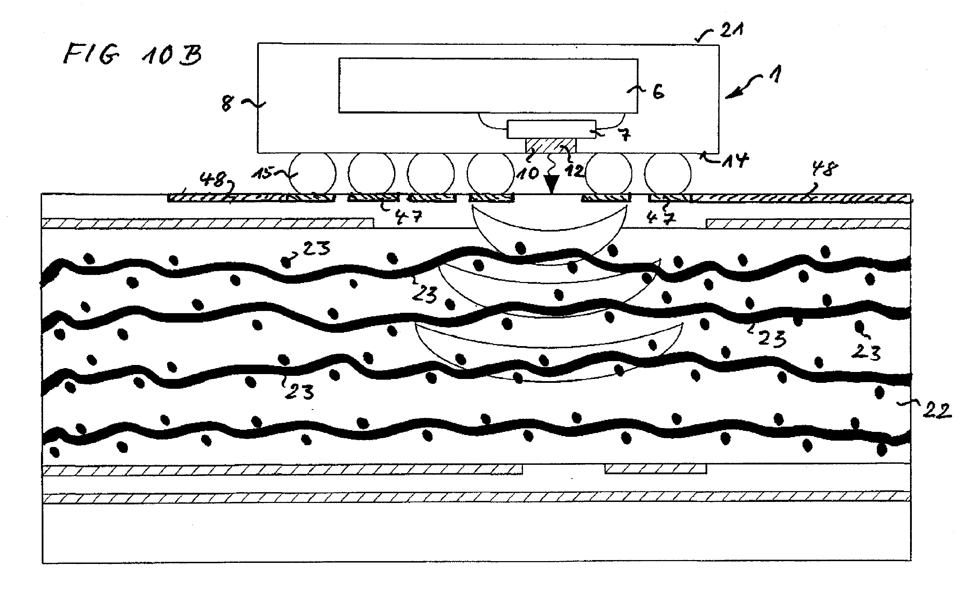

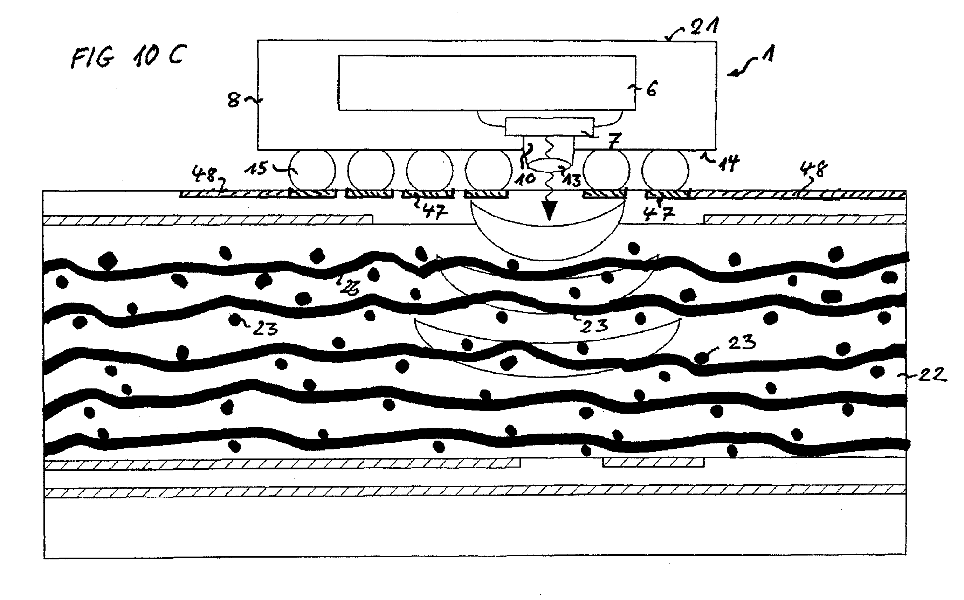

Figur 10 zeigt schematische Darstellungen einer Halbleiterschaltung mit einem elektrooptischen Halbleitermodul 1 gemäß Figur 1 auf einer mit Glasfasern 23 verstärkten Schaltungsplatine 22.

In Figur 10A wird ein Halbleitermodul 1 mit einer Sende- und Empfangsöffnung 10 auf der Oberflächenmontageseite 14 auf die Schaltungsplatine 22 aufgebracht und mit entsprechenden Leiterbahnen der Schaltungsplatine werden die Kugelkontakte auf entsprechenden Kontaktanschlussflächen 47 mit Leiterbahnen 48 elektrisch verbunden. Wenn das elektrooptische Halbleitermodul über die Sende- und Empfangsöffnung 10 optische Signale in die Schaltungsplatine 22 emittiert, so werden diese Signalfolgen von den Glasfasern, die eigentlich zur Verstärkung der Schaltungsplatine 22 vorgesehen sind, optisch übertragen und können an anderen Stellen der Platine empfangen und ausgewertet werden.

Figur 10B zeigt eine schematische Darstellung der Halbleiterschaltung wie in Figur 10A mit einem elektrooptischen Halbleitermodul gemäß Figur 1, wobei die Sende- und Empfangsöffnung in dem Fall der Figur 10B durch eine transparente Kunststoffauffüllung vor Beschädigung geschützt ist. Figur 10 C zeigt eine weitere Modifikation der Halbleiterschaltung gemäß Figur 10A, wobei die Sende- und Empfangsöffnung des Halbleitermoduls auf der Oberflächenmontageseite 14 zusätzlich ein Linsensystem 13 aufweist, das die optische Strahlung bündeln, fokussieren oder streuen kann..

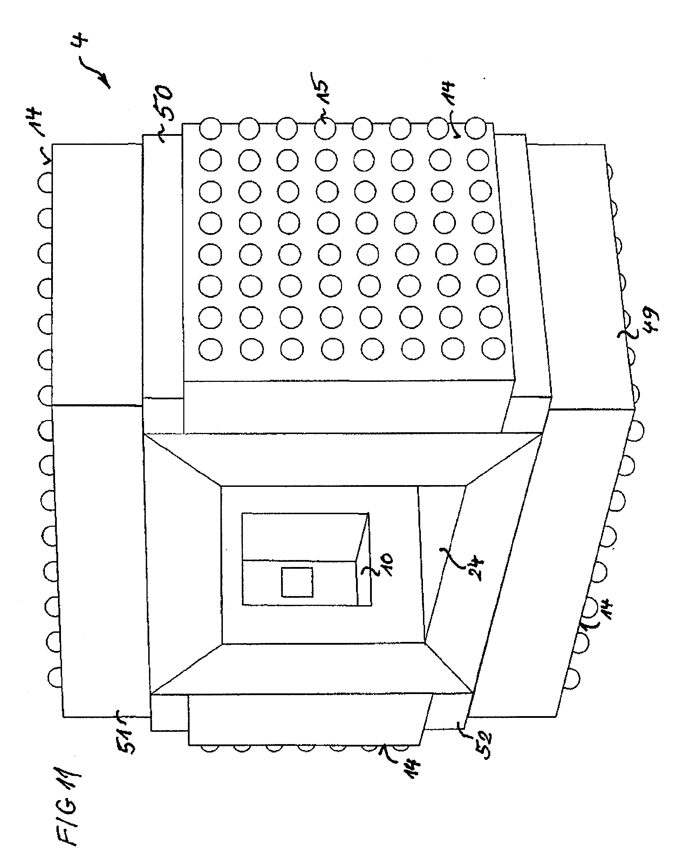

Figur 11 zeigt eine schematische perspektivische Darstellung eines elektrooptischen Halbleitermoduls 4 gemäß einer vierten Ausführungsform der Erfindung. Dieses elektrooptische Halbleitermodul 4 setzt sich aus vier elektrooptischen Halbleitermodulen 49, 50, 51 und 52 der zweiten Ausführungsform der Erfindung zusammen. Diese elektrooptischen Halbleitermodule 49 bis 52 bilden ein Durchgangsfenster 24, in dem Sende- und Empfangsöffnungen 10 der elektrooptischen Halbleitermodule 49 bis 52 paarweise einander gegenüberliegen, so dass ein Austausch von Daten zwischen den einzelnen derart in einem Viereck angeordneten Halbleitermodulen 49 bis 52 möglich ist. Die Kugelkontakte 15 auf den Oberflächenmontageseiten 14 der zu diesem neuen elektrooptischen Halbleitermodul 4 zusammengestellten elektrooptischen Halbleitermodule 49 bis 52 sind frei zugänglich.

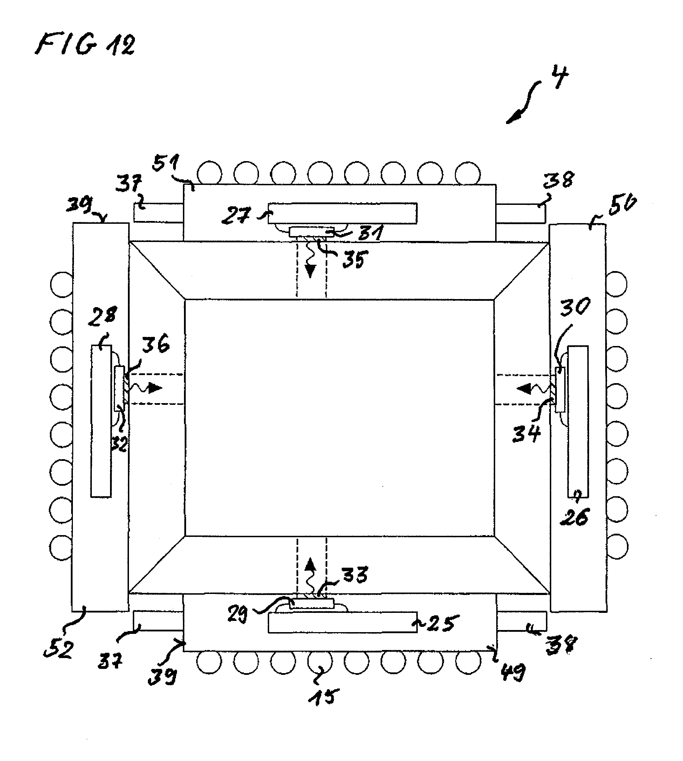

Figur 12 zeigt einen schematischen Querschnitt durch das elektrooptische Halbleitermodul 4 gemäß Figur 11. Dieser Querschnitt zeigt die Anordnung der vier Datenkommunikationschips 25, 26, 27 und 28 sowie der auf den Datenkommunikationschips 25 bis 28 angeordneten elektrooptischen Chips 29 bis 32. Außerdem zeigt dieser Querschnitt die Anordnung der Sende- und Empfangsöffnungen 33 bis 36, die paarweise zueinander angeordnet sind, und die freie Zugänglichkeit der nach außen angeordneten Kugelkontakte 15 der Halbleitermodule 49 bis 52 gemäß der zweiten Ausführungsform der Erfindung.

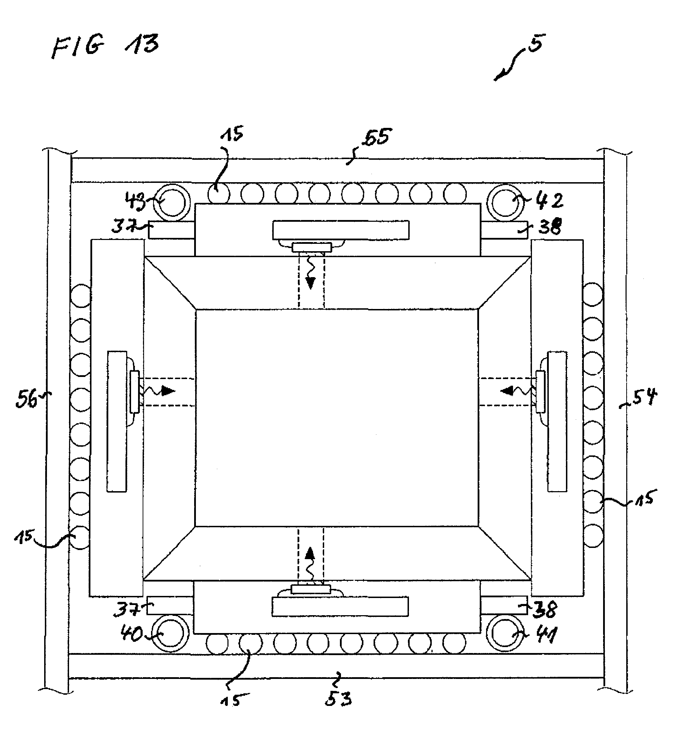

Figur 13 zeigt einen schematischen Querschnitt durch ein elektrooptisches Halbleitermodul 5 gemäß einer fünften Ausführungsform der Erfindung. Dieser Querschnitt unterscheidet sich von dem Querschnitt gemäß Figur 12 dadurch, dass zusätzlich zu den Kühlfahnen 37 und 38 weitere Kühlleitungen 40, 41, 42 und 43 mit den Kühlfahnen 37 und 38 zusammenwirken und dadurch die Kühlung des Halbleitermoduls 5 intensivieren. Außerdem ist hier schematisch gezeigt, wie beispielsweise die Kugelkontakte 15 auf entsprechenden Schaltungsplatinen 53, 54, 55 und 56 angeordnet werden können.

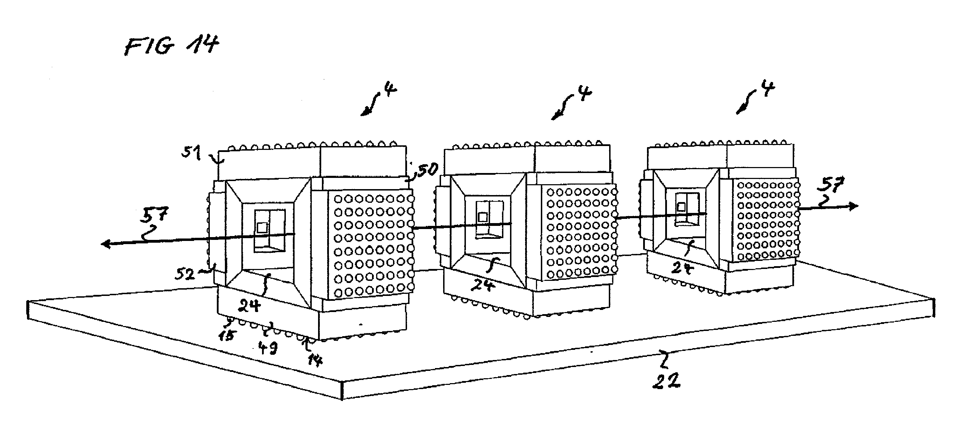

Figur 14 zeigt eine schematische Darstellung einer Halbleiterschaltung auf einer Schaltungsplatine 22, auf der drei zueinander ausgerichtete elektrooptische Halbleitermodule 4 der vierten Ausführungsform der Erfindung angeordnet sind, so dass die Fenster 24 der drei elektrooptischen Module 4 einen optischen Pfad 57 beispielsweise mit Hilfe eines Wellenleiters, der durch die Durchgangsfenster 24 hindurchgeführt ist, bilden können, in den die Sende- und Empfangsöffnungen 10 der elektrooptischen Module 4 einkoppeln können. Figur 14 zeigt damit die hohe Flexibilität der erfindungsgemäßen Lösung.

## Patentansprüche

1. Elektrooptisches Halbleitermodul mit mindestens einem Datenkommunikationschip (6) und einem elektrooptischen Chip (7), wobei
- die Chips (6, 7) in einem gemeinsamen Kunststoffgehäuse (8) eingebettet sind, und
- die Chips (6, 7) über Verbindungselemente (9) elektrisch in Verbindung stehen,
**dadurch gekennzeichnet, dass** der elektrooptische Chip (7) auf dem Datenkommunikationschip (6) fixiert ist und das Kunststoffgehäuse (8) eine Sende- und Empfangsöffnung (10) aufweist, durch welche optische Strahlung (11) von oder zu dem elektrooptischen Chip (7) aus- und/oder eintritt.

2. Halbleitermodul nach Anspruch 1, **dadurch gekennzeichnet, dass** die Sende- und Empfangsöffnung (10) eine transparente Kunststofffüllung (12) aufweist.

3. Halbleitermodul nach Anspruch 1 oder Anspruch 2, **dadurch gekennzeichnet, dass** die Sende- und Empfangsöffnung (10) ein Linsensystem (13) aufweist.

4. Halbleitermodul nach einem der vorhergehenden Ansprüche, **dadurch gekennzeichnet, dass** die Sende- und Empfangsöffnung (10) auf einer Oberflächenmontageseite (14) angeordnet ist, und dass die Oberflächenmontageseite (14) des Halbleitermoduls (1) Kugelkontakte (15) aufweist, und dass die Sende- und Empfangsöffnung (10) mindestens anstelle einer Kugelkontaktposition (16) auf der Oberflächenmontageseite (14) angeordnet ist.

5. Halbleitermodul nach einem der vorhergehenden Ansprüche, **dadurch gekennzeichnet, dass** die Sende- und Empfangsöffnung (10) gegenüberliegend zu einer Oberflächenmontageseite (14) des Halbleitermoduls (1) angeordnet ist.

6. Halbleitermodul einem der vorhergehenden Ansprüche, **dadurch gekennzeichnet, dass** der elektrooptische Chip (7) auf der Oberseite (17) und ein weiterer elektrooptischer Chip (20) auf der Rückseite (18) des Datenkommunikationschips (6) angeordnet sind und das Halbleitermodul (1) Sende- und Empfangsöffnungen (10) zur Oberflächenmontageseite (14) und zu der gegenüberliegenden Seite (21) hin aufweist.

7. Halbleitermodulschaltung **dadurch gekennzeichnet, dass** mehrere Halbleitermodule (1 bis 3) gemäß einem der vorhergehenden Ansprüche auf einer Schaltungsplatine (22) mit Glasfaserverstärkung angeordnet sind und über die Glasfasern (23) der Glasfaserverstärkung optisch miteinander kommunizieren, wobei ein pulskodemodulierter multiplexer bzw. zeitversetzter Zugriff der Datenkommunikationschips (6) über die elektrooptischen Chips (7) auf das Glasfasergewebe vorgesehen ist.

8. Halbleitermodul nach einem der Ansprüche 1 bis 6, **dadurch gekennzeichnet, dass** das Halbleitermodul (1 bis 5) mehrere Datenkommunikationschips (6) mit elektrooptischen Chips (7) und optischen Sende- und Empfangsöffnungen (10) um ein Durchgangsfenster (24) gruppiert aufweist, wobei die Datenkommunikationschips (6) des Halbleitermoduls (1 bis 3) über die elektrooptischen Chips (7) und die Sende- und Empfangsöffnungen (10) untereinander kommunizieren.

9. Halbleitermodul nach Anspruch 8, **dadurch gekennzeichnet, dass** vier Datenkommunikationschips (25 bis 28) mit elektrooptischen Chips (29 bis 32) vorhanden sind, wobei die elektrooptischen Chips und die optischen Sende- und Empfangsöffnungen (33 bis 36) um ein rechtwinkliges Durchgangsfenster (24) gruppiert sind, wobei gegenüberliegende Datenkommunikationschips (25, 27; 26, 28) des Halbleitermoduls (5) über die elektrooptischen Chips (29, 31; 30, 32) und die Sende- und Empfangsöffnungen (33 bis 36) miteinander kommunizieren.

10. Halbleitermodul nach Anspruch 8, **dadurch gekennzeichnet, dass** das Halbleitermodul (1) Kühlfahnen (37, 38) aufweist, auf denen der Datenkommunikationschip (6) montiert ist, wobei Enden der Kühlfahnen (37, 38) aus den Seitenflächen (39) des Kunststoffgehäuses (8) herausragen.

11. Halbleitermodul nach Anspruch 10, **dadurch gekennzeichnet, dass** das Halbleitermodul (1) Kühlleitungen (40 bis 43) aufweist, die als aktive Kühlelemente mit den Kühlfahnen (37, 38) mechanisch verbunden sind.

12. Halbleitermodulschaltung, **dadurch gekennzeichnet, dass** mehrere Halbleitermodule (1 bis 5) gemäß einem der Ansprüche 8 bis 11 mit Durchgangsfenster (24) auf einer Schaltungsplatine (44) derart angeordnet sind, dass sich ein zentraler optischer Kommunikationspfad (45) durch die Durchgangsfenster (24) erstreckt, und ein pulskodemodulierter multiplexer bzw. zeitversetzter Zugriff der Datenkommunikationschips (25 bis 28) über die elektrooptischen Chips (29 bis 32) auf den zentralen optischen Kommunikationspfad (45) vorgesehen ist.
